# FASCICULE DE BREVET EUROPEEN

(11) **EP 1 601 101 B1**
(45) Date de publication et mention de la délivrance du brevet: **10.01.2007**
(21) Numéro de dépôt: 05104420.4
(22) Date de dépôt: 24.05.2005
(51) Int. Cl.: H03H 7/42

(54) **Transformateur à changement de mode et filtre passe-bas**
BALUN Transformator und Tiefpassfilter
Balun transformer and low pass filter

(30) Priorité: 25.05.2004 FR 0451023
(43) Date de publication de la demande: 30.11.2005
(73) Titulaire: ST MICROELECTRONICS S.A., 92120 Montrouge (FR)
(72) Inventeur: Ezzeddine, Hilal, 37000 Tours (FR)
(74) Mandataire: de Beaumont, Michel

(56) Documents cités:
- EP-A- 1 416 575
- WO-A-01/37323
- US-A1- 2003 151 881

## Description

La présente invention concerne le domaine des transformateurs à changement de mode (BALUN) dont le rôle est de transformer un signal de mode commun en un signal de mode différentiel et inversement, et plus particulièrement de tels transformateurs destinés à être associés à un filtre passe-bas.

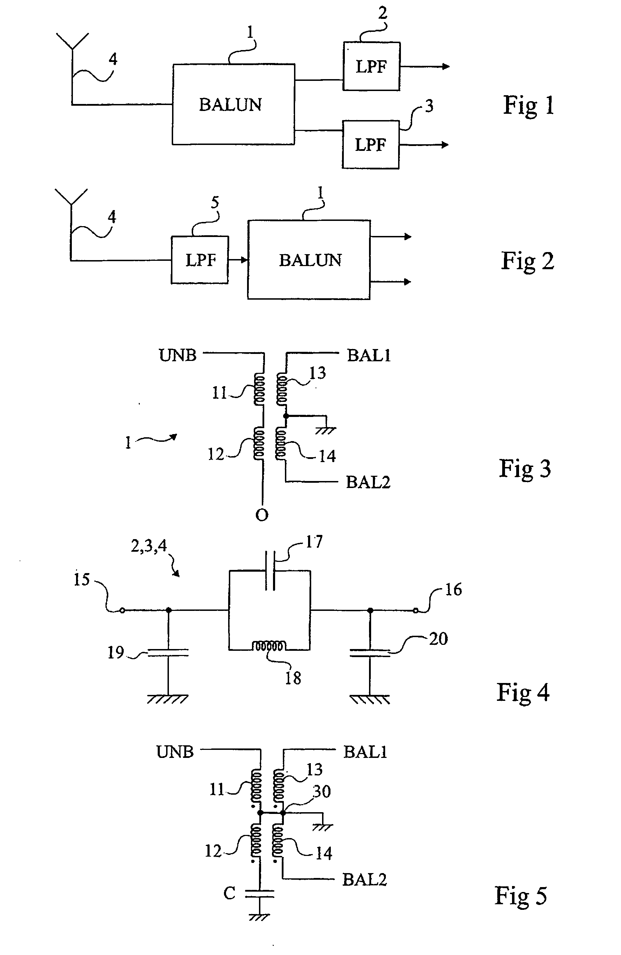

La figure 1 représente, de façon très schématique et sous forme de blocs, un premier exemple d'association d'un transformateur à changement de mode 1 (BALUN) et de filtres passe-bas 2 et 3 (LPF). Dans cet exemple, les filtres 2 et 3 sont connectés aux sorties différentielles du balun 1 dont l'entrée de mode commun est connectée à une antenne 4. Il s'agit là d'un exemple d'application courant de transformateurs à changement de mode utilisés dans des téléphones portables. Ils sont alors destinés à convertir les signaux reçus sur l'antenne pour qu'ils soient exploitables par les circuits internes au téléphone.

La figure 2 représente un deuxième exemple classique de montage associant un filtre passe-bas 5 à un transformateur à changement de mode 1. Dans cet exemple, le filtre passe-bas est placé en amont du transformateur 1, c'est-à-dire entre l'antenne 4 et l'entrée de mode commun du balun 1.

La figure 3 représente le schéma électrique équivalent d'un transformateur à changement de mode 1. Côté mode commun, deux éléments inductifs 11 et 12 sont connectés en série entre un accès de mode commun UNB et un port laissé ouvert O. Côté mode différentiel, deux éléments inductifs 13 et 14 sont connectés en série entre les deux accès de mode différentiel BAL1 et BAL2. Le point milieu de l'association en série des inductances 13 et 14 est connecté à la masse.

Les éléments 11 à 14 sont dimensionnés en fonction de la fréquence centrale de la bande passante souhaitée pour le balun, chaque enroulement inductif 11 à 14 ayant une longueur égale au quart de la longueur d'onde de cette fréquence centrale.

La figure 4 représente un exemple classique de schéma électrique équivalent d'un filtre 2, 3 ou 4 passe-bas. Un tel filtre est généralement symétrique et comporte deux bornes 15 et 16 d'entrée-sortie entre lesquelles sont connectés un premier condensateur 17 en parallèle avec une inductance 18, chaque borne 15 et 16 étant par ailleurs connectée à la masse par un condensateur, respectivement 19 ou 20.

Les éléments du filtre sont dimensionnés en fonction de la fréquence de coupure souhaitée pour le filtre, cette fréquence étant choisie en fonction de la bande passante du transformateur 1.

Le fait que les deux éléments (filtre passe-bas et transformateur à changement de mode) soient séparés l'un de l'autre nuit à la compacité d'intégration des circuits, donc à la miniaturisation.

La présente invention vise à réduire l'encombrement de transformateurs à changement de mode intégrés avec des filtres passe-bas. L'invention vise notamment à permettre l'intégration, sur un même circuit, d'un transformateur à changement de mode et de son filtre passe-bas.

L'invention vise également à proposer une structure de transformateur à changement de mode intégré qui serve également de filtre passe-bas différentiel.

Pour atteindre ces objets ainsi que d'autres, la présente invention prévoit un transformateur à changement de mode intégré, comprenant :
un premier enroulement plan dans un premier niveau conducteur dont une borne d'extrémité externe définit une borne d'entrée-sortie de mode commun ;
un deuxième enroulement plan électriquement en série avec le premier enroulement et réalisé dans un deuxième niveau conducteur ;
au moins un condensateur reliant une borne d'extrémité externe du deuxième enroulement à la masse ;
un troisième enroulement réalisé dans ledit deuxième niveau conducteur et dont une borne d'extrémité externe définit un premier accès de mode différentiel ; et
un quatrième enroulement, électriquement en série avec le troisième et réalisé dans ledit premier niveau conducteur, une borne d'extrémité externe du quatrième enroulement définissant une deuxième borne d'accès de mode différentiel et les extrémités centrales de tous les enroulements étant interconnectées à la masse, de façon à former un filtre passe-bas différentiel.

Selon un mode de réalisation de la présente invention, au moins les premier, troisième et quatrième enroulements ont des longueurs identiques choisies en fonction de la fréquence centrale de la bande passante souhaitée pour le transformateur à changement de mode.

Selon un mode de réalisation de la présente invention, le deuxième enroulement a une longueur identique aux trois autres.

Selon un mode de réalisation de la présente invention, ledit condensateur est dimensionné en fonction d'une fréquence de réjection souhaitée, supérieure à la fréquence centrale de la bande passante du transformateur à changement de mode.

Selon un mode de réalisation de la présente invention, les premier et quatrième enroulements sont interdigités de même que les deuxième et troisième enroulements.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 4 qui ont été décrites précédemment sont destinées à exposer l'état de la technique et le problème posé ;
la figure 5 représente le schéma électrique équivalent d'un mode de réalisation d'un transformateur à changement de mode selon la présente invention ;
la figure 6 illustre la réalisation empilée des enroulements inductifs d'un transformateur à changement de mode selon la présente invention ; et
la figure 7 est une vue de dessus d'un transformateur intégré selon l'invention.

Les mêmes éléments ont été désignés par de mêmes références aux différentes figures. Pour des raisons de clarté, seuls les éléments qui sont nécessaires à la compréhension de l'invention ont été représentés aux figures et seront décrits par la suite. En particulier, les différents éléments connectés en entrée-sortie d'un transformateur à changement de mode ou filtre passe-bas différentiel selon l'invention n'ont pas été détaillés, l'invention étant compatible avec toute utilisation classique d'un transformateur à changement de mode, associé à un filtre passe-bas côté mode commun, ou à deux filtres passe-bas côté mode différentiel.

Une caractéristique de la présente invention est de placer électriquement, en série avec le premier enroulement (connecté à l'accès de mode commun) d'un transformateur à changement de mode, une impédance inductive et capacitive de filtrage connectée à la masse. Une autre caractéristique de l'invention est de relier également à la masse le point milieu de l'association en série du premier enroulement avec cette impédance, et de coupler deux à deux les inductances du transformateur à changement de mode.

La figure 5 représente le schéma électrique équivalent d'un transformateur à changement de mode constituant également un filtre passe-bas différentiel selon la présente invention.

Comme dans un transformateur à changement de mode classique, deux bornes BAL1 et BAL2 d'accès de mode différentiel sont connectées l'une à l'autre par deux éléments inductifs 13 et 14 en série, le point milieu 30 étant relié à la masse (ou à tout autre potentiel de référence). Toujours comme dans un transformateur classique, un accès mode commun UNB est relié à un enroulement inductif 11 constituant un primaire du transformateur, cet enroulement étant en série avec un deuxième enroulement primaire 12 qui classiquement est laissé en l'air.

Selon la présente invention, un condensateur C relie l'extrémité libre de l'enroulement 12 à la masse. De plus, le point milieu de l'association en série des enroulements 11 et 12 est également connecté à la masse.

Pour l'effet transformateur, les éléments inductifs 11 et 13 sont couplés l'un à l'autre de même que les éléments inductifs 12 et 14.

L'inductance 12 et le condensateur C forment un élément réjecteur de fréquence dont la fréquence de coupure dépend de leurs valeurs respectives.

De préférence, pour optimiser la fonction du transformateur balun, les enroulements inductifs 11, 13 et 14 sont réalisés avec une longueur de λ/4, où λ représente la fréquence centrale de la bande passante souhaitée pour le transformateur à changement de mode. Cette condition de longueur n'est pas impérative pour l'inductance 12 mais, comme on le verra par la suite, il est plus simple de réaliser cet enroulement de la même longueur que tous les autres.

Selon l'invention, la structure représentée en figure 5 est intégrée en réalisant toutes les inductances 11, 12, 13 et 14 sous la forme d'enroulements conducteurs plans, le couplage étant obtenu en empilant ces enroulements conducteurs. De plus, les enroulements sont entrelacés ou interdigités deux à deux dans un même niveau conducteur.

On peut considérer que l'ajout de l'élément réjecteur constitue un secondaire supplémentaire au transformateur à changement de mode. Ainsi, l'enroulement 11 représente l'enroulement primaire, les enroulements 13 et 14 constituent le premier secondaire fournissant les sorties différentielles, et un deuxième secondaire du transformateur est constitué par l'élément filtrant (l'inductance 12 et le condensateur C). En effet, par la connexion à la masse de l'enroulement 11, seul le couplage via les enroulements 13 et 14 permet un transfert d'énergie entre les enroulements 11 et 12.

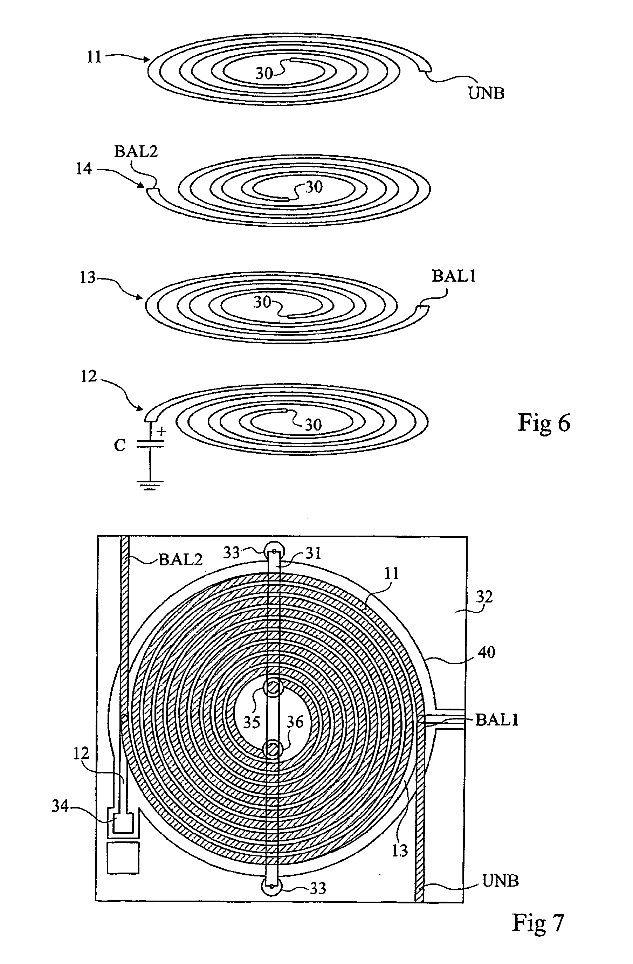

La figure 6 illustre, par une vue en perspective éclatée un exemple de réalisation des différents enroulements d'un transformateur-filtre selon l'invention.

La figure 7 est une vue de dessus d'un transformateur-filtre intégré selon l'invention.

En figure 6, les interconnexions entre les différents enroulements n'ont pas été représentées. De plus, les enroulements réalisés dans le même niveau conducteur qu'un niveau supérieur ont été représentés en pointillés.

On suppose que l'enroulement supérieur dans l'orientation verticale de la figure 6 est l'enroulement primaire 11 dont l'extrémité externe définit la borne UNB. L'extrémité centrale 30 de la spire est reliée par un via 35 (figure 7) à un deuxième niveau de métallisation (supposé inférieur) dans lequel est par ailleurs formé un plan de masse 32 (figure 7). Le via 35 connecte l'extrémité centrale (point 30 du point de vue électrique) du deuxième enroulement 12 formé dans ce deuxième niveau conducteur. Comme l'illustre la figure 7, les enroulements du deuxième niveau sont formés dans une ouverture circulaire 40 du plan de masse 32. Le via 35 se prolonge vers un troisième niveau de métallisation (par exemple supérieur) dans lequel est formé un pont 31 suivant le diamètre de la structure pour connecter le point central 30 au plan de masse 32. En variante, un autre via que le prolongement du via 35 est prévu. Des vias 33 connectent les extrémités du pont 31 au plan 32.

L'enroulement 12 a son extrémité externe reliée à une première électrode 34 du condensateur C réalisée dans le même niveau de métallisation. L'autre électrode du condensateur est formée dans le niveau de métallisation du plan de masse 32. Le diélectrique du condensateur est formé par la couche isolante (non visible aux figures) séparant les premier et deuxième niveaux de métallisation. En variante, les deux électrodes du condensateur sont formées dans les deuxième et troisième niveaux ou dans les premier et troisième niveaux.

Le premier enroulement 13 secondaire est formé dans le même niveau de métallisation que l'enroulement 12 de façon à pouvoir être couplé avec l'enroulement 11. Son extrémité centrale est connectée à la masse 32 par un via 36, le pont 31 et les vias 33. L'extrémité externe de l'enroulement 13 définit la borne BAL1. Les enroulements 12 et 13 sont interdigités pour être formés dans le même niveau conducteur. Enfin, le deuxième enroulement secondaire 14 est formé dans le même niveau de métallisation que l'enroulement 11 en étant interdigité avec celui-ci et son extrémité externe définit la borne BAL2. Le via 36 sert de connexion des extrémités centrales des enroulements 13 et 14.

L'ensemble de la structure de l'invention peut être intégrée dans trois niveaux de métallisation et, avec des sens de rotation appropriés pour les enroulements, on peut minimiser les vias et ponts pour ressortir vers l'extérieur de la structure les différents contacts.

Comme l'illustre la figure 7, l'encombrement du transformateur à changement de mode correspond à l'encombrement d'un transformateur classique dont les enroulements inductifs sont de longueur λ/4. Par conséquent, l'invention permet d'intégrer le filtre passe-bas différentiel au transformateur à changement de mode, sans en augmenter la taille.

La valeur à donner au condensateur C dépend de la fréquence de coupure souhaitée pour le filtre réjecteur. Pour une valeur d'inductance donnée, plus le condensateur est faible, plus la fréquence de coupure est repoussée vers des fréquences élevées.

A titre d'exemple particulier de réalisation, pour un transformateur à changement de mode comprenant la fonction filtre passe-bas différentiel et destiné à une bande de fréquences centrée sur une fréquence de 900 mégahertz, en dimensionnant tous les enroulements pour avoir une même longueur de λ/4, un condensateur d'environ 2 picofarads fournit une fréquence de réjection d'environ 1,8 gigahertz tandis qu'un condensateur d'environ 0,5 picofarads fournit une fréquence de réjection d'environ 2,8 gigahertz.

Un avantage de la présente invention est que la fréquence de réjection peut être ajustée uniquement en faisant varier la valeur du condensateur C, sans qu'il soit nécessaire d'intervenir sur les enroulements inductifs.

Un autre avantage de la présente invention est qu'en combinant les fonctions filtre et transformateur dans une seule structure, on réduit les pertes d'insertion par rapport à celles d'une structure classique.

Un autre avantage de la présente invention est que les paramètres de déséquilibre d'amplitude (amplitude imbalance) entre les deux voies BAL1 et BAL2, de même que de déséquilibre de phase (phase imbalance) restent conformes à celle d'un transformateur à changement de mode classique, dans la mesure où les enroulements ont des longueurs maintenues en tronçons de λ/4.

Bien entendu, la présente invention est susceptible de diverses variantes et modifications qui apparaîtront à l'homme de l'art. En particulier, les dimensions à donner aux différents enroulements inductifs ainsi que les valeurs à donner au condensateur dépendent de l'application et notamment de la fréquence de réjection souhaitée pour une fréquence de fonctionnement donnée du transformateur à changement de mode. Ces dimensionnements sont à la portée de l'homme du métier à partir des indications fonctionnelles données ci-dessus. En outre, la fabrication d'un transformateur de l'invention en utilisant les techniques habituellement employées dans l'industrie électronique pour réaliser des circuits intégrés sur différents substrats (par exemple, silicium ou verre) est à la portée de l'homme du métier. En particulier, l'association d'un transformateur de l'invention formé dans des niveaux de métallisation servant par ailleurs aux connexions et reprises de contacts d'autres composants intégrés dans un même circuit constitue une adaptation à sa portée.

## Revendications

1. Transformateur à changement de mode intégré, **caractérisé en ce qu'**il comprend :
un premier enroulement plan (11) dans un premier niveau conducteur dont une borne d'extrémité externe définit une borne d'entrée-sortie de mode commun (UNB) ;
un deuxième enroulement plan (12) électriquement en série avec le premier enroulement et réalisé dans un deuxième niveau conducteur ;
au moins un condensateur (C) reliant une borne d'extrémité externe du deuxième enroulement à la masse ;
un troisième enroulement (13) réalisé dans ledit deuxième niveau conducteur et dont une borne d'extrémité externe définit un premier accès (BAL1) de mode différentiel ; et
un quatrième enroulement (14), électriquement en série avec le troisième et réalisé dans ledit premier niveau conducteur, une borne d'extrémité externe du quatrième enroulement définissant une deuxième borne d'accès de mode différentiel (BAL2) et les extrémités centrales de tous les enroulements étant interconnectées à la masse, de façon à former un filtre passe-bas différentiel.

2. Transformateur selon la revendication 1, dans lequel au moins les premier (11), troisième (13) et quatrième (14) enroulements ont des longueurs identiques choisies en fonction de la fréquence centrale de la bande passante souhaitée pour le transformateur à changement de mode.

3. Transformateur selon la revendication 2, dans lequel le deuxième enroulement (12) a une longueur identique aux trois autres.

4. Transformateur selon l'une quelconque des revendications 1 à 3, dans lequel ledit condensateur (C) est dimensionné en fonction d'une fréquence de réjection souhaitée, supérieure à la fréquence centrale de la bande passante du transformateur à changement de mode.

5. Transformateur selon l'une quelconque des revendications 1 à 4, dans lequel les premier (11) et quatrième (14) enroulements sont interdigités de même que les deuxième (12) et troisième (13) enroulements.

## Claims

1. A mode-switching transformer, **characterized in that** it comprises:
a first planar winding (11) in a first conductive level having an external end terminal defining a common-mode input/output terminal (UNB);
a second planar winding (12) electrically in series with the first winding and formed in a second conductive level;
at least one capacitor (C) connecting an external end terminal of the second winding to ground;
a third winding (13) formed in said second conductive level and having an external end terminal defining a first differential mode access (BAL1); and
a fourth winding (14), electrically in series with the third one and formed in said first conductive level, an external end terminal of the fourth winding defining a second differential-mode access terminal (BAL2) and the central ends of all windings being interconnected to ground, to form a differential low-pass filter.

2. The transformer of claim 1, wherein at least the first (11), third (13), and fourth (14) windings have identical lengths selected according to the central frequency of the passband desired for the mode-switching transformer.

3. The transformer of claim 2, wherein the second winding (12) has a length identical to the three others.

4. The transformer of any of claims 1 to 3, wherein said capacitor (C) is sized according to a desired rejection frequency, greater than the central frequency of the mode-switching transformer passband.

5. The transformer of any of claims 1 to 4, wherein the first (11) and fourth (14) windings, as well as the second (12) and third (13) windings, are interdigitated.

## Patentansprüche

1. Modus-Schalttransformator, **dadurch gekennzeichnet, dass** er Folgendes aufweist:
eine erste planare Wicklung (11) mit einem ersten Leitfähigkeitsniveau mit einem externen Endanschluss, der einen Gemeinschaftsmodus-Eingangs-/Ausgangsanschluss (UNB) definiert;
eine zweite planare Wicklung (12), die elektrisch in Serie geschaltet ist mit der ersten Wicklung und mit einem zweiten Leitfähigkeitsniveau Wicklung ausgebildet ist;
wenigstens einen Kondensator (C), der einen externen Endanschluss der zweiten Wicklung mit Masse verbindet;
eine dritte Wicklung (13), die mit dem zweiten Leifähigkeitsniveau ausgebildet ist und einen externen Endanschluss aufweist, der einen ersten Differentialmoduszugriffsanschluss (BAL1) definiert; und
eine vierte Wicklung (14), die elektrisch in Serie geschaltet ist mit der dritten Wicklung, und die mit dem ersten Leitfähigkeitsniveau ausgebildet ist, wobei ein externer Endanschluss der vierten Wicklung einen zweiten Differentialmoduszugriffsanschluss (BAL2) definiert und
die zentralen Enden aller Wicklungen mit Masse verbunden sind, um einen differentiellen Tiefpassfilter zu bilden.

2. Transformator nach Anspruch 1, wobei wenigstens die erste (11), dritte (13) und vierte (14) Wicklung identische Längen besitzen, die gemäß der Mittenfrequenz des Passbandes, das für den Modus-Schalttransformator gewünscht ist, ausgewählt ist

3. Transformator nach Anspruch 2, wobei die zweite Wicklung (12) eine Länge besitzt, die identisch zu den drei anderen ist.

4. Transformator nach einem der Ansprüche 1 bis 3, wobei der Kondensator (C) gemäß einer gewünschten Unterdrückungsfrequenz bemessen ist, die größer ist als die Mittenfrequenz des Passbandes des Modus-Schalttransformators,

5. Transformator nach einem der Ansprüche 1 bis 4, wobei die erste (11) und vierte (14) Wicklung, sowie die zweite (12) und dritte (13) Wicklung ineinander verschachtelt bzw ineinandergreifend sind.
